# EUROPEAN PATENT SPECIFICATION

(11) **EP 1 358 291 B1**
(45) Date of publication and mention of the grant of the patent: **10.08.2005**
(21) Application number: 02713494.9
(22) Date of filing: 29.01.2002
(51) Int. Cl.: C09J 5/06

(54) **METHOD FOR ADHERING SUBSTRATES USING LIGHT ACTIVATABLE ADHESIVE FILM**
VERFAHREN ZUM KLEBEN VON SUBSTRATEN UNTER VERWENDUNG EINER LICHTAKTIVIERBAREN KLEBSTOFFFOLIE
PROCEDE D'ADHESION DE SUBSTRATS AU MOYEN D'UN FILM ADHESIF PHOTO-ACTIVABLE

(30) Priority: 30.01.2001 JP 2001022030
(43) Date of publication of application: 05.11.2003
(73) Proprietor: 3M Innovative Properties Company, St. Paul, MN 55133-3427 (US)
(72) Inventor: YAMAGUCHI, Hiroaki, Hachioji-city, Tokyo 192-0363 (JP); KITAMURA, Tetsu, Kawasaki-city, Kanagawa 214-0033 (JP)
(74) Representative: VOSSIUS & PARTNER
(86) International application number: PCT/US2002/002540
(87) International publication number: WO 2002/061010

(56) References cited:
- WO-A-00/00566
- PATENT ABSTRACTS OF JAPAN vol. 016, no. 437 (C-0984), 11 September 1992 (1992-09-11) & JP 04 150974 A (THREE BOND CO LTD), 25 May 1992 (1992-05-25)
- PATENT ABSTRACTS OF JAPAN vol. 1999, no. 12, 29 October 1999 (1999-10-29) & JP 11 181391 A (NIPPON KAYAKU CO LTD), 6 July 1999 (1999-07-06)
- PATENT ABSTRACTS OF JAPAN vol. 2000, no. 16, 8 May 2001 (2001-05-08) & JP 2001 007128 A (SHARP CORP), 12 January 2001 (2001-01-12)

## Description

The present invention relates to a method for adhering substrates using a light activatable adhesive film. More particularly, the present invention relates to a method for connecting circuits using a light activatable anisotropically conductive adhesive film.

In a liquid crystal display device, the electrodes of a glass-made display panel and a flexible circuit, generally known as a TCP (tape carrier package), having mounted thereon a driving integrated circuit (IC) for actuating the display panel are connected by an anisotropically conductive adhesive film. Usually, this conductive adhesive film is obtained by dispersing conductive particles in an insulating adhesive such as an epoxy resin and forming the dispersion into a film. This adhesive film is interposed between two circuits standing opposite to each other and then heated while applying a pressure to complete the bonding. This bonding provides a state such that conductive particles are electrically conductive to each other between the connecting terminals of two opposing circuits in the applied pressure direction, namely the thickness direction of the adhesive film, resulting in electrical connectivity between the opposing connecting terminals.

In recent years, for the purpose of reducing the cost and weight of liquid crystal panels, liquid crystal panels including plastic substrates or flexible circuits having a PET film substrate have been developed. In the case of conventionally known conductive adhesive films, the press-bonding temperature is as high as 150 to 200°C and if the above-described liquid panel or flexible circuit is bonded at such a high temperature thermal damage can occur which can cause deformation of the electrode moiety or cracking at the electrodes of the display panel. This thermal damage can thus disadvantageously bring about connection failure. The connection pitch between the electrode part of the display panel and the flexible circuit is usually from 100 to 200 µm, however, the demands of modem display panels require a finer connection pitch including a pitch of 50 µm or less. This finer connection pitch however, results in deformation of the flexible circuit, due to the heat applied during thermocompression bonding of the adhesive film, and slippage from the electrode pattern of the display panel.

In order to solve these problems, light activatable adhesive films capable of thermocompression bonding at a lower temperatures have been developed as well as methods of connecting the circuits using this adhesive film.

For example, Japanese Unexamined Patent Publication (Kokai) No. 11-60899 describes a method for electrically connecting conductors using an ultraviolet activatable anisotropically conductive adhesive film. The method includes the steps of disposing the ultraviolet activatable anisotropically conductive adhesive film on a first circuit substrate, irradiating the adhesive film with ultraviolet rays using a high-pressure mercury lamp, aligning the electrode of a second circuit substrate to face the electrode of the first circuit substrate, and bonding them under heat and pressure.

Japanese Unexamined Patent Publication (Kokai) No. 8-146436 describes a lamination method for producing liquid crystal panels including bonding one transparent substrate to another transparent substrate with a photocurable adhesive. Once the photocurable adhesive is interposed between transparent.substrates it is cured using ultraviolet light. In this method, ultraviolet light at wavelengths of 300 nm or less is eliminated to limit deterioration of the transparent substrates.

Furthermore, Japanese Unexamined Patent Publication (Kokai) No. 9-320131 describes a method of bonding two disks with an ultraviolet curable adhesive where each disk comprises an ultraviolet transmissive substrate. This method includes disposing the ultraviolet curable adhesive between the two substrates and irradiating the ultraviolet curable adhesive with ultraviolet light through the substrates to cure the adhesive. In this method, light at a wavelength of 2 to 3 µm or more is filtered out using a quartz glass. This method also includes the use of a cooling air to prevent secondary heating of the substrate from the filter or the ultraviolet light source.

EP-A-1 005 509 refers to an epoxy resin composition comprising an alicyclic epoxy resin, a styrenic thermoplastic elastomer with at least one epoxy group therein, and an ultraviolet-active cationic polymerisation catalyst. A corresponding anisotropically conductive adhesive film as well as an electrical connecting method for establishing electrical connections between two different substrates are also disclosed.

WO 00/00566 describes a thermosetting hot-melt adhesive composition comprising an epoxy component comprising a polyethylene copolymer having epoxy groups, a cationic polymerisation catalyst, and a thermoplastic polymer having no epoxy groups. A heat-bonding film adhesive as well as an adhering method are also described.

In JP-A-2001/007128 an accelerator is used for accelerating the thermosetting of a reactive substance in a thermosetting resin.

Generally, known bonding methods include the use of a light curable adhesive, low-temperatures and short thermocompression bonding times. However, these methods include the use of light to cure a light curable adhesive. When light is used to cure a light curable adhesive, curing times can be decreased through the use of high-intensity light sources such as high-pressure mercury lamps and metal halide lamps. In conventional bonding methods, the light curable adhesive is irradiated after it is disposed on a substrate. The use of high intensity light sources such as the above-described high-pressure mercury lamp or metal halide lamp as a light source have deleterious effects in this case as the transparent substrate also gets irradiated and, depending on the material of the transparent substrate, may undergo deterioration such as coloration or clouding. In the case of a resin-made substrate, the material may be decomposed and cracks may be generated thereon.

Furthermore, upon irradiation of the substrate, the substrate temperature elevates and, depending on the substrate material and its coefficient of thermal expansion, can expand. This thermal expansion of the substrate can result in slippage between the two substrates during bonding and curing, and ultimately connection failure.

The object of the present invention is to solve the above-described problems by providing a method of adhering substrates using a light activatable adhesive film without involving irradiation of the substrate, especially the circuit substrate, while preventing the deterioration of the substrate.

The present invention provides a method for adhering two substrates, wherein a light activatable adhesive film is irradiated to activate the film. The light activatable film comprises an alicyclic epoxy resin, a glycidyl group containing epoxy resin, a light activatable cationic polymerization catalyst, a cationic polymerization inhibitor, and a thermoplastic elastomer or resin. The first surface of the activated adhesive film is disposed to contact a first substrate and a second substrate is disposed to contact the second surface of the activated adhesive film. These substrates are heat-pressed and bonded to attain adhesion between the first and second substrates. It is preferable to use an ultraviolet activatable adhesive film as a light activatable adhesive film and to use ultraviolet light as a light source.

The present invention also provides a method for electrically connecting circuits present on the surfaces of two substrates. The method includes irradiating, preferably with ultraviolet radiation, a light activatable adhesive film, preferably an ultraviolet activatable anisotropically conductive adhesive film, to activate the film. The first surface of the activated anisotropically conductive adhesive film is then disposed to contact a circuit on a first substrate and a second substrate is disposed to put the circuit on the second substrate into contact with the second surface of the activated anisotropically conductive adhesive film. The substrates are heat-pressed and bonded to attain anisotropically conductive adhesion between the circuits on the first and second substrates. The light activatable film comprises an alicyclic epoxy resin, a glycidyl group containing epoxy resin, a light activatable cationic polymerization catalyst, a cationic polymerization inhibitor, and a thermoplastic elastomer or resin. The invention is defined hereunder:
1. A method for adhering two substrates comprising irradiating a light activatable adhesive film to activate the film, wherein the light activatable adhesive film comprises an alicyclic epoxy resin, a glycidyl group-containing epoxy resin, a light activatable cationic polymerization catalyst, a cationic polymerization inhibitor, and a thermoplastic elastomer or resin and optionally wherein the glycidyl group-containing epoxy resin comprises an average of at least two glycidyl groups per molecule, contacting the first surface of the activated adhesive film with a first substrate, contacting a second substrate with the second surface of said activated adhesive film, and compression bonding these substrates; optionally wherein the light activatable adhesive film is irradiated with ultraviolet light.
2. A method for electrically connecting circuits provided on the surfaces of two substrates, comprising irradiating a light activatable adhesive film to activate the film, contacting the first surface of the activated anisotropically conductive adhesive film with the circuit on a first substrate, contacting the circuit on a second substrate with the second surface of said activated anisotropically conductive adhesive film, and compression bonding these substrates to attain anisotropically conductive adhesion between said circuits on said first and second substrates, wherein the light activatable adhesive film comprises an alicyclic epoxy resin, a glycidyl group-containing epoxy resin, a light activatable cationic polymerization catalyst, a cationic polymerization inhibitor, and a thermoplastic elastomer or resin and optionally wherein the glycidyl group-containing epoxy resin comprises an average of at least two glycidyl groups per molecule and wherein the light activatable adhesive film is irradiated with ultraviolet light.
3. A method according to item 1 or 2, wherein the alicyclic epoxy resin comprises an average of at least two alicyclic epoxy groups per molecule.
4. A method according to any of items 1 to 3, wherein the alicyclic epoxy resin comprises from 90 to 500 epoxy equivalents.
5. A method according to item 4, wherein the alicyclic epoxy resin comprises from 100 to 400 epoxy equivalents.
6. A method according to item 5, wherein the alicyclic epoxy resin comprises from 120 to 300 epoxy equivalents.
7. A method according to item 6, wherein the alicyclic epoxy resin comprises from 210 to 235 epoxy equivalents.
8. A method according to any of items 1 to 7, wherein the alicyclic epoxy resin is vinylcyclohexene dioxide, 3,4-epoxycyclohexylmethyl-3,4-epoxycyclohexanecarboxylate, bis(3,4-epoxycyclohexyl)adipate, or 2-(3,4-epoxycyclohexyl-5,5-spiro-3,4-epoxy)cyclohexane-meta-dioxane.
9. A method according to any of items 1 to 8, wherein the glycidyl group-containing epoxy resin comprises an average of at least two glycidyl groups per molecule.
10. A method according to any of items 1 to 9, wherein the glycidyl group-containing epoxy resin comprises from 170 to 5500 epoxy equivalents.
11. A method according to item 10, wherein the glycidyl group-containing epoxy resin comprises from 170 to 1000 epoxy equivalents.
12. A method according to item 11, wherein the glycidyl group-containing epoxy resin comprises from 170 to 500 epoxy equivalents.
13. A method according to item 12, wherein the glycidyl group-containing epoxy resin comprises from 175 to 210 epoxy equivalents.
14. A method according to any of items 1 to 13, wherein the glycidyl group-containing epoxy resin comprises glycidyl esters of bisphenol A, glycidyl esters of bisphenol F, polyfunctional phenol-novolac epoxy resins, ortho-cresol epoxy resins, or glycidyl hexahydrophthalate.
15. A method according to any of items 1 to 14, wherein the weight ratio of alicyclic epoxy resin to glycidyl group-containing epoxy resin is from 20:80 to 98:2.
16. A method according to item 15, wherein the weight ratio of alicyclic epoxy resin to glycidyl group-containing epoxy resin is from 40:60 to 94:6.
17. A method according to item 16, wherein the weight ratio of alicyclic epoxy resin to glycidyl group-containing epoxy resin is from 50:50 to 90:10.
18. A method according to item 17, wherein the weight ratio of alicyclic epoxy resin to glycidyl group-containing epoxy resin is from 50:50 to 80:20.
19. A method according to any of items 1 to 18, wherein the light activatable cationic polymerization catalyst is an aryldiazonium salt, diaryliodonium salt, triarylsulfonium salt, triarylselenium salt, or iron-arene complex.
20. A method according to item 19, wherein the iron-arene complex is xylene-cyclopentadienyl iron (II) hexafluoroantimonate, cumene-cyclopentadienyl iron (II) hexafluorophosphate or xylene-cyclopentadienyl iron (II) tris(trifluoromethylsulfonyl) methide.
21. A method according to any of items 1 to 20, wherein the light activatable film comprises from 0.05 to 10.0 parts by weight light activatable cationic polymerization catalyst per 100 parts by weight of the epoxy resin.
22. A method according to item 21, wherein the light activatable film comprises from 0.075 to 7.0 parts by weight light activatable cationic polymerization catalyst per 100 parts by weight of the epoxy resin.
23. A method according to item 22, wherein the light activatable film comprises from 0.1 to 4.0 parts by weight light activatable cationic polymerization catalyst per 100 parts by weight of the epoxy resin.
24. A method according to item 23, wherein the light activatable film comprises from 1.0 to 2.5 parts by weight light activatable cationic polymerization catalyst per 100 parts by weight of the epoxy resin.
25. A method according to any of items 1 to 24, wherein the cationic polymerization inhibitor is a crown ether, toluidine, phosphine, or triazine.
26. A method according to any of items 1 to 25, wherein the light activatable film comprises from 0.01 to 10.0 equivalents cationic polymerization inhibitor with respect to the light activatable cationic polymerization catalyst.
27. A method according to item 26, wherein the light activatable film comprises from 0.05 to 5.0 equivalents cationic polymerization inhibitor with respect to the light activatable cationic polymerization catalyst.
28. A method according to item 27, wherein the light activatable film comprises from 0.10 to 3.0 equivalents cationic polymerization inhibitor with respect to the light activatable cationic polymerization catalyst.
29. A method according to item 28, wherein the light activatable film comprises from 0.4 to 2.0 equivalents cationic polymerization inhibitor with respect to the light activatable cationic polymerization catalyst.
30. A method according to any of items 1 to 29, wherein the light activatable film further comprises conductive particles.
31. A method according to any of items 1 to 30, wherein the light activatable film further comprises from 0.1 to 30% by volume conductive particles with respect to the total volume of the composition minus the volume of the conductive particles.
32. A method according to item 31, wherein the light activatable film further comprises from 0.5 to 10% by volume conductive particles with respect to the total volume of the composition minus the volume of the conductive particles.
33. A method according to item 32, wherein the light activatable film further comprises from 1 to 5% by volume conductive particles with respect to the total volume of the composition minus the volume of the conductive particles.
34. A method according to any of items 1 to 33, wherein the light activatable film is irradiated with ultraviolet light.

The invention may be more completely understood in consideration of the following detailed description of various enibodiments of the invention in connection with the accompanying drawings, in which:

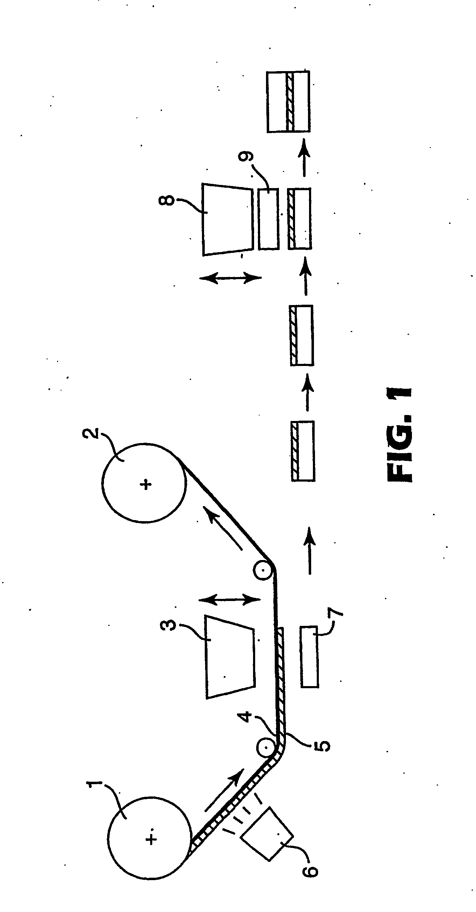

Figure 1 is a schematic illustration of a procedure for adhering substrates using a light activatable adhesive film in accordance with the present invention.

According to the method of the present invention, after a light activatable adhesive film is activated by exposure to light, the adhesive film is transferred and disposed on substrates and thereafter the substrates are heat-pressed and bonded. Thus, the substrates are not exposed to light during activation of the light activatable adhesive film and avoid possible deterioration due to such exposure.

One practical embodiment of the present invention is described below by referring to Fig. 1. A light activatable adhesive film 5 with a separator 4 is unwound and delivired from a reel 1 and then conveyed toward a press-bonding head 3. Before reaching the press-bonding head 3, the light activatable adhesive film 5 is irradiated by a light source 6, preferably an ultraviolet light source, and thereby activated. The activated light activatable adhesive film 5 is transferred on a first substrate 7. Thereafter, the separator 4 is taken up by a reel 2 and the substrate 7 having transferred thereon the activated adhesive film 4 is conveyed toward a press-bonding head 8 where a second substrate 9 is heat-pressed and bonded to the substrate 7 by the heat-pressing head 8.

If the first substrate and the second substrate both have circuits thereon, the circuits can be electrically connected by using a light activatable anisotropically conductive adhesive film as the adhesive film.

The term "light activatable anisotropically conductive adhesive film" as used herein means a film formed of an adhesive having capability of attaining adhesion between two circuit substrates when these circuit substrates are laminated one on another and the circuits on the circuit substrates are made electrically conductive in the thickness direction but not in the plane direction of the substrate so as not to short the adjacent circuits on the circuit substrates. For example light activatable anisotropically conductive adhesive films as used herein mean films capable of adhesive electroconductivity upon adhering. Anisotropic conductivity is a phenomenon occurring when substrates are bonded to each other by thermocompression bonding using an adhesive film, because non-conductive adhesive components exclusive of conductive particles are fluidized by the heat and pressure generated during thermocompression bonding. As a result of the fluidized non-conductive particles, the circuits on two facing substrates are made electrically conductive with each other via the conductive particles but due to the presence of non-conductive adhesive components, the conductivity is not exerted in the plane direction of the substrate.

The electroconductive adhesive described in Japanese Unexamined Patent Publication No. 11-60899 uses an ultraviolet activatable cationic polymerization catalyst as the catalyst for curing an alicyclic epoxy resin and is therefore workable for a very short period of time. In the method disclosed in this patent publication. thermocompression bonding is performed immediately after irradiation of the adhesive with ultraviolet light and therefore the short workable time of the adhesive may not cause any trouble. The method disclosed herein however, includes conveying the substrate to a press-bonding head after irradiation. Thus, an adhesive film having an excessively short workable time is disadvantageous. Additionally, the use of adhesive films with short workable times is not applicable to the present invention which can include maintenance time for installation of the semiconductor device or temporary down time which would typically require light activatible adhesive films with workable times of 10 minutes or more for example. Furthermore, light activatable adhesive films for use in the present invention are preferably formed of an adhesive having all of the following properties: (1) high storage stability at room temperature, for example, the usable state can be maintained at least for 30 days, (2) the adhesive can be subject to a relatively high temperature before irradiation and activation, thus facilitating drying and formation of the film within a short period of time, (3) the adhesive can be rapidly cured, preferably within 1 minute, more preferably within 30 seconds, still more preferably within 10 seconds, at a low temperature of 100 to 130°C at the time of thermocompression bonding after the activation, and (4) after the substrates are connected to each other, excellent connection stability can be exhibited.

The light activatable adhesive according to the present invention is an adhesive including as useful components an epoxy resin containing (1) an alicyclic epoxy resin (2) a glycidyl group-containing epoxy resin, (3) a light activation cationic polymerization catalyst, and (4) a cationic polymerization inhibitor. Adhesives including such components result in adhesives possessing the above-described properties in good balance. To form a film from this light activatable anisotropically conductive adhesive, a thermoplastic elastomer or a resin is added. A light activatable anisotropically conductive adhesive can be obtained by adding conductive particles into the light activatable adhesive.

Though not wishing to be bound by any particular theory, it is believed that the alicyclic epoxy resin allows rapid curing at low temperatures when combined with a light activatable cationic polymerization catalyst. The glycidyl group-containing epoxy resin prolongs the workable time of the adhesive film after activation. The glycidyl group-containing epoxy resin has a lower reactivity than that of the alicyclic epoxy resin. The light activatable cationic polymerization catalyst catalyzes an epoxy ring-opening reaction by producing a cationic active species such as a Lewis acid upon irradiation. The cationic polymerization inhibitor retards or inhibits the cationic polymerization reaction by displacing a part of the cationic polymerization catalyst and by sequestering the Lewis acid or other cationic active species in the cationic polymerization, thereby prolonging the usable time of the adhesive film.

In order to attain good electrical connection between a substrate and another substrate using a light activatable anisotropically conductive adhesive film, it is necessary that the adhesive component is fully fluidized by the heat and pressure during thermocompression bonding and is satisfactorily eliminated from in between the conductive particles and the circuit on the circuit substrate. The fluidity of the adhesive component varies depending on the intrinsic viscosity of the resin in the adhesive and the elevation of the viscosity accompanying the heat-curing reaction. When the adhesive composition contains an alicyclic epoxy resin and a light activatable cationic polymerization catalyst, the polymerization reaction does not proceed until the catalyst has been activated by irradiation. Thus, such adhesives maintain a useful state and high stability at room temperature for at least 30 days. However, after the activation of the catalyst upon irradiation, the composition can be heat-cured at low temperatures within a short period of time. Since the heat-curing reaction rapidly proceeds after activation of the catalyst and the viscosity of the adhesive composition increases within a short period of time due to the heat-curing reaction, the thermocompression bonding step must be quickly performed. In order to retard the curing reaction, a cationic polymerization inhibitor can be added. However, even in the case where such an inhibitor is added, if a long period of time exists between irradiation and thermocompression bonding, by taking time to align the circuit substrates with each other, for example, the adhesive component between the electroconductive particles and the circuit on the circuit substrate cannot be satisfactorily eliminated due to the increase in viscosity of the adhesive component accompanying the heat-curing reaction. The failure to eliminate the adhesive component from in between the conductive particles and the circuit can result in an unstable electrical connection. If the composition contains the glycidyl group-containing epoxy resin, the heat-curing reaction after irradiation proceeds relatively slowly. Thus, the workable time after the activation can be prolonged. However, in order to attain satisfactory curing and thereby ensure good electrical connection, it is necessary either to elevate the press-bonding temperature or prolong the press-bonding time.

An anisotropically conductive adhesive film obtained from an anisotropically conductive adhesive including an epoxy resin containing both alicyclic epoxy resin and glycidyl group-containing epoxy resin, a light activatable cationic polymerization catalyst and a cationic polymerization inhibitor, undergoes a limited increase in viscosity after irradiation due to the presence of the glycidyl group-containing epoxy resin and the cationic polymerization inhibitor. Thus, such an anisotropically conductive adhesive film possesses a prolonged workable time after irradiation. Additionally, such an anisotropically conductive adhesive film can be satisfactorily cured even at low temperatures, ensuring stable electrical connections, due to the presence of the highly reactive alicyclic epoxy resin and the light activatable cationic polymerization catalyst.

As such, the light activatable adhesive films and light activatable anisotropically conductive adhesive films as disclosed herein possess many advantages over conventional films. For example, the curing reaction does not proceed before the activation by irradiation resulting in increased storage stability of the film at room temperature. Additionally, the film can be subjected to temperatures up to 80°C prior to activation by irradiation without deleterious effects. This allows the film to be quickly dried at elevated temperatures without initiating the curing process which allows the film to be efficiently manufactured. Subsequent to irradiation and activation of the film the workable time of the film at room temperature can be prolonged to 10 minutes or more, preferably 30 minutes or more, so that press-bonding can be satisfactorily performed. Furthermore, when making an electrical connection that includes a component composed of a material which readily deforms upon the application of heat, such as a circuit substrate made of FPC or TAB based on a polymer material such as polyester or polyimide, or PCB, polycarbonate or polyethersulfone based on a glass-reinforced epoxy material for example, deformation of the material can be reduced to a minimum because the thermocompression bonding step can be performed rapidly. For example a thermocompression bonding step including an anisotropically conductive adhesive film of the present invention can be performed within 1 minute, more preferably 30 seconds, and still more preferably 10 seconds at temperatures from 100°C to 130°C. In addition to the above examples, the light activatable adhesive films of the present invention exhibit excellent interconnection characteristics.

The components constituting the light activatable adhesive films or light activatable anisotropically conductive adhesive films of the present invention are individually described below.

### Alicyclic Epoxy Resin

As mentioned above, the alicyclic epoxy resin improves the rate and temperature at which the adhesive composition is cured. The combination of this component with the light activatable cationic polymerization catalyst allows rapid curing at low temperatures. Because of the low viscosity, it also acts to increase intimate contact between the composition and the substrate. The alicyclic epoxy resin is an epoxy resin with an average of at least two alicyclic epoxy groups per molecule. For example, useful alicyclic epoxy resins include those that have two epoxy groups in the molecule such as vinylcyclohexene dioxide, 3,4-epoxycyclohexylmethyl-3,4-epoxycyclohexanecarboxylate, bis(3,4-epoxycyclohexyl)adipate and 2-(3,4-epoxycyclohexyl-5,5-spiro-3,4-epoxy)cyclohexane-meta-dioxane. Polyfunctional cycloaliphatic epoxy resins having 3, 4 or more epoxy groups in the molecule (for example, Epolide GT: available from Daicel Chemical Industries, Ltd.) are also useful.

Useful alicyclic epoxy resins include those having epoxy equivalents in the range of 90 to 500, preferably 100 to 400, more preferably 120 to 300 and most preferably 210 to 235. Alicyclic epoxy resins including fewer than 90 epoxy equivalents reduce the durability and adhesive strength of the composition which may reduce the reliability of the connection. Alicyclic epoxy resins including more than 500 epoxy equivalents increase the viscosity of the composition such that its flow properties are poor during thermocompression bonding and its reactivity is decreased which may also reduce the reliability of the connection.

### Glycidyl Group-Containing Epoxy Resin

As mentioned above, the combination of glycidyl group-containing epoxy resin with a cationic polymerization retarder extends the workable life of the composition after activation by irradiation. Additionally, even though the glycidyl group-containing epoxy resin possesses lower reactivity than the alicyclic epoxy resin it maintains reactivity at elevated temperatures. When using an adhesive film containing only the alicyclic epoxy resin with no glycidyl group-containing epoxy resin, the curing reaction tends to proceed even at low temperatures such as room temperature for example, resulting in a shorter workable life after activation by irradiation. Thus, if the time period between activation and thermocompression bonding is extended, due to the need for alignment of the circuit substrates for example, the increase in composition viscosity due to premature curing prevents adequate elimination of the adhesive components between the conductive particles and the conductor on each circuit substrate. This can lead to unstable electrical connections. The glycidyl group-containing epoxy resin compensates for this limitation of alicyclic epoxy resins. Useful glycidyl group-containing epoxy resins include epoxy resins with an average of at least two glycidyl groups in the molecule and containing no cationic polymerization-inhibiting groups, such as amines or sulfur- or phosphorous-containing groups for example. Examples of useful glycidyl group-containing epoxy resins include bisphenol A-type epoxy resins synthesized from bisphenol A and epichlorohydrin, low-viscosity bisphenol F-type epoxy resins, polyfunctional phenol-novolac epoxy resins, and ortho-cresol epoxy resins. Glycidyl ester-type epoxy resins such as glycidyl hexahydrophthalate ester are also useful.

Useful glycidyl-containing epoxy resins include those having epoxy equivalents from 170 to 5500, preferably from 170 to 1000, more preferably from 170 to 500 and most preferably from 175 to 210. Glycidyl-containing epoxy resins having fewer than 170 epoxy equivalents suffer from reduced durability and limited adhesive strength while those having more than 5500 epoxy equivalents suffer from increased viscosity. Such glycidyl-containing epoxy resins posses low reactivity and poor flow properties during thermocompression bonding which can lead to the reduction of connection reliability.

### Mixing Ratio for Alicyclic Epoxy Resin and Glycidyl Group-Containing Epoxy. Resin

The alicyclic epoxy resin and glycidyl group-containing epoxy resin provide a satisfactory balance of the desired properties for compositions of the present invention. Specifically, it is possible to provide an adhesive satisfactorily exhibiting both the low-temperature rapid curability of the cycloaliphatic epoxy resin and the long shelf life at room temperature of the glycidyl group-containing epoxy resin. The alicyclic epoxy resin/glycidyl group-containing epoxy resin weight ratio is usually 20:80 to 98:2, preferably 40:60 to 94:6, more preferably 50:50 to 90:10 and most preferably 50:50 to 80:20. If the amount of the alicyclic epoxy resin is less than 20% based on the total amount of the alicyclic epoxy resin and the glycidyl group-containing epoxy resin, the curing properties at low temperatures may be reduced and the adhesive strength and connection reliability may be inadequate. If an amount of the alicyclic epoxy resin is greater than 98%, the curing reaction may be promoted even at about room temperature, thus shortening the workable life of the film after irradiation.

### Light Activatable Cationic Polymerization Catalyst

The light activatable cationic polymerization catalyst is a compound that catalyzes an epoxy ring-opening reaction by producing a cationic active species such as a Lewis acid by irradiation. Examples of useful polymerization catalysts include aryldiazonium salts, diaryliodonium salts, triarylsulfonium salts, triarylselenium salts, and iron-arene complexes. Particularly useful cationic polymerization catalysts include iron-arene complexes because of their thermal stability, xylene-cyclopentadienyl iron (II) hexafluoroantimonate, cumene-cyclopentadienyl iron (II) hexafluorophosphate and xylene-cyclopentadienyl iron (II) tris(trifluoromethylsulfonyl) methide.

The light activatable cationic polymerization catalyst is present in an amount from 0.05 to 10.0 parts by weight, preferably from 0.075 to 7.0 parts by weight, more preferably from 0.1 to 4.0 parts by weight and most preferably from 1.0 to 2.5 parts by weight, with respect to 100 parts by weight of the epoxy resin. If the amount of light activatable cationic polymerization catalyst present is less than 0.05 parts by weight, the curing properties at low temperatures may be reduced and the adhesive strength and connection reliability may be inadequate. If the amount of light activatable cationic polymerization catalyst present is greater than 10.0 parts by weight, the curing reaction may be promoted at about room temperature, and the shelf life at about room temperature may be reduced.

### Cationic Polymerization Inhibitor

The cationic polymerization inhibitor retards or inhibits the cationic polymerization reaction by substituting a part of the cationic polymerization catalyst and by sequestering the Lewis acid or other cationic active species present during the cationic polymerization. Useful cationic polymerization inhibitors include crown ethers such as 15-crown-5, 1,10-phenanthroline and its derivatives, toluidines such as N,N-diethyl-metatoluidine, phosphines such as triphenylphosphine, and triazines.

The cationic polymerization inhibitor is present in an amount from 0.01 to 10.0 equivalents, preferably from 0.05 to 5.0 equivalents, more preferably from 0.10 to 3.0 equivalents and most preferably from 0.4 to 2.0 equivalents, with respect to the light activatable cationic polymerization catalyst. If the cationic polymerization inhibitor is present in an amount greater than 10.0 equivalents, the curing properties at low temperature may be reduced and the adhesive strength and connection reliability may be inadequate. If the cationic polymerization inhibitor is present in an amount less than 0.05 equivalents, the curing reaction may be promoted even at about room temperature, and the shelf life at about room temperature may therefore be reduced.

### Conductive Particles

Useful conductive particles include conductive particles such as carbon particles or metal particles of silver, copper, nickel, gold, tin, zinc, platinum, palladium, iron, tungsten, molybdenum, or solder, or particles prepared by covering the surface of these particles with a conductive coating of e.g. a metal. It is also possible to use non-conductive particles of a polymer such as polyethylene, polystyrene, phenol resin, epoxy resin, acryl resin or benzoguanamine resin, or glass beads, silica, graphite or a ceramic, whose surfaces have been covered with a conductive coating of e.g. a metal.

The mean particle size of the conductive particles used may vary depending on the electrode width and the spacing between the adjacent electrodes used for connection. For example, if the electrode width is 50 µm and the spacing between adjacent electrodes is 50 µm (i.e., the electrode pitch is 100 µm), a mean particle size of 3 to 20 µm is appropriate. The use of an anisotropically conductive adhesive film including conductive particles with a mean particle size of 3 to 20 µm, provides for satisfactory conductive characteristics while also adequately preventing short circuiting between adjacent electrodes. In most cases, since the pitch of the electrodes used for connection between the two circuit substrates will be from 50 to 1000 µm, the mean particle size of the conductive particles is preferably in the range of 2 to 40 µm. If the mean particle size of the conductive particles is less than 2 µm, they may be buried in pits in the electrode surface thus losing their function as conductive particles. If the mean particle size of the conductive particles is greater than 40 µm they may tend to produce short circuiting between adjacent electrodes.

The amount of the conductive particles added may vary depending on the area of the electrodes used and the mean particle size of the conductive particles. A satisfactory connection can usually be achieved with a few conductive particles present per electrode, such as 2 to 10 for example. If lower electrical resistance is desired, the conductive particles may be included in the composition in an amount of 10 to 300 per electrode. If high pressure is to be applied during thermocompression bonding, the number of conductive particles on each electrode may be increased to 300 to 1000, thus evenly distributing the pressure so as to achieve a satisfactory connection. The amount of conductive particles with respect to the total volume of the composition minus the conductive particles is usually from 0.1 to 30% by volume, preferably from 0.5 to 10% by volume and more preferably from 1 to 5% by volume. If the amount is less than 0.1% by volume, there may be a greater probability of the conductive particles being absent on the electrode when connected, thus increasing the risk of lower connection reliability. If the amount is greater than 30% by volume, short circuiting between adjacent electrodes may occur.

### Thermoplastic Elastomer or Resin

The thermoplastic' elastomer or resin is a component that is included in order to use the light activatable adhesive as an adhesive film. The thermoplastic elastomer or resin increases the formability of the adhesive film while also enhancing the impact resistance of the resulting adhesive film and alleviating residual internal stress produced by the curing reaction, for improved bond reliability. Useful thermoplastic elastomers include polymer components composed of a hard segment which is rigid below a certain temperature and a soft segment that possesses a rubber-like elasticity. Useful elastomers include styrene-based thermoplastic elastomers, and styrene-based elastomers which are block copolymers including, for example, a styrene unit in the hard segment and a polybutadiene unit or polyisoprene unit in the soft segment. Examples of such useful elastomers include styrene-butadiene-styrene block copolymers (SBS), styrene-isoprene-styrene block copolymers (SIS), styrene-(ethylene-butylene)-styrene block copolymers (SEBS), where the diene component in the soft segment is hydrogenated, and styrene-(ethylene-propylene)-styrene block copolymers (SEPS). Additional useful elastomers include styrene-based thermoplastic elastomers with reactive groups, such as elastomers of the type which are epoxy-modified by glycidyl methacrylate, or elastomers of the type in which the unsaturated bond of a conjugated diene is epoxidized. The presence of highly polar reactive groups in such elastomers increases the compatibility of the elastomer with the epoxy resin so that the range of formulations with epoxy resins is widened. Additionally the presence of highly polar reactive groups in such elastomers allow for crosslinking with the epoxy resin resulting in improved bonding reliability after curing due to heat and humidity resistance. An example of an epoxidized styrene-based elastomer is Epofriend A1020 (Daicel Chemical Industries, Ltd.). In the present invention, a thermoplastic resin may also be used instead of a thermoplastic elastomer. Because the thermoplastic resin must be eliminated by fluidization during thermocompression bonding of the adhesive film in order to ensure a satisfactory electrical connection between the conductors on the bonded substrates, useful thermoplastic resins include those with a Tg of no greater than the thermocompression bonding temperature. Such thermoplastic resins include, for example, polystyrene resins.

The thermoplastic elastomer or resin is present in an amount from 10 to 900 parts by weight, preferably from 20 to 500 parts by weight, more preferably from 30 to 200 parts by weight and most preferably from 40 to 100 parts by weight with respect to 100 parts by weight of the epoxy resin. If the thermoplastic elastomer or resin is present in an amount less than 10 parts by weight the film fonnability of the-adhesive may be reduced. If the thermoplastic elastomer or resin is present in an amount greater than 900 parts by weight the low temperature flow properties of the adhesive may be reduced to the point of poor contact when the conductive particles and the circuit substrate are bonded which can result in increased electrical resistance, lower connection reliability, and lower bonding strength.

### Other Additives

The light activatable adhesive film of the invention may also contain an added cationic polymerization reaction accelerator in addition to the components mentioned above. Addition of a reaction accelerator can further improve the low temperature curability and rapid curing characteristics of the film. Useful reaction accelerators include di-tert-butyloxalate for example. The reaction accelerator is present in an amount from 0.01 to 5 parts by weight, preferably from 0.05 to 3 parts by weight and more preferably from 0.1 to 2 parts by weight with respect to 100 parts by weight of the cycloaliphatic epoxy resin and glycidyl group-containing epoxy resin. For increased bonding strength between the circuit substrate and the adhesive composition, there may also be included a coupling agent, for example a silane coupling agent such as γ-glycidoxypropyltrimethoxysilane, and β-(3,4-epoxycyclohexyl)ethyl trimethoxysilane.

Other additives such as antioxidants, including hindered phenol-based antioxidants for example, diols, including bis(phenoxyethanol)fluorene) for example, chain transfer agents, sensitizers, tackifiers, thermoplastic resins, fillers, flow modifiers, plasticizers, and antifoaming agents may also be added so long as the desired characteristics of the present invention are not compromised.

### Method for Production of Light Activatable Adhesive Film

The light activatable adhesive film may be obtained by preparing a coating solution containing the aforementioned adhesive in an appropriate solvent such as tetrahydrofuran (THF) for example, coating the solution onto a support such as a polymer film for example, and then drying the coated film. Useful coating means include any appropriate coating means such as a knife coater for example. The drying is carried out at any temperature less than 80°C at which the solvent evaporates yet does not initiate the curing reaction. The thickness of the formed adhesive film is from 5 to 100 µm in order to avoid gaps between connections when the circuit substrates are connected together by thermocompression bonding, and to allow the necessary and sufficient packing.

The resulting light activatable adhesive film is provided on a separator, and irradiated with light, preferably ultraviolet light using a light irradiation device to activate the adhesive film. A mercury lamp, a metal-halide lamp or a mercury-xenon lamp having high intensity in the wavelength range between 300 to 400 nm is useful as a light irradiation source for example. Mercury lamps and mercury-xenon lamps typically have the highest intensity at 365 nm. Metal-halide lamps typically consist of a metal-halide compound such as gallium halide or an iron halide of iodine or bromine in the light bulb and irradiate more efficiency in a wide range of wavelengths than mercury lamps. The irradiation dose is usually adjusted to a dose sufficient for activation of the light activation cationic polymerization catalyst such as 100 to 10,000 mJ/cm² for example.

In the above irradiation process, ultraviolet light of wavelengths shorter than 300 nm, which have higher energy, tends to be absorbed into the adhesive film more efficiently and change into heat. The heat can prematurely cure the adhesive film to varying degrees and it results in a shortened workable time between irradiation and subsequent bonding. Filtering or attenuation wavelengths lower than 300 nm can improve workable time. A light source used in this invention can also have a filter to cut visible light with wavelengths typically in the range between 450 to 600 nm or a filter absorbing infrared light with wavelengths typically in the range between 800 to 4000 nm.

Additionally, the adhesive film can further be protected from undesired heat generated during irradiation through the use of a stream air blown onto the surface of the adhesive film to cool it.

The activated adhesive film is then transferred onto a first circuit substrate by a heat-pressing head, and then a second circuit substrate is transferred onto the unoccupied surface of the adhesive film and heat-pressed by a heat-pressing head. The heat-pressing temperature is from 100 to 130°C, and the bonding pressure is appropriately selected so as to achieve adequate electrical connection after bonding. The pressure applied is usually in the range of 1 to 5 MPa. Useful bonding times include those from 10 seconds to one minute or longer.

The invention will be further characterized by the following examples. These examples are not meant to limit the scope of the invention which is defined in the claims

### EXAMPLES

### Preparation of Anisotropically Conductive Adhesive Film

After mixing 5.6 g of the alicyclic resin (Epolide™ GT401, available from Daicel Chemical Industries Ltd., Osaka Japan, epoxy equivalents = 219), 1.4 g of glycidyl group-containing epoxy resin (Epikote™ 154, available from Yuka Shell Epoxy Ltd., epoxy equivalents = 179), and 3 g of styrene-butadiene-styrene block copolymer (Epofriend™ A1020 available from Daicel Chemical Industries Ltd., epoxy equivalents = 510) with 12 g of tetrahydrofuran, the was stirred to uniformity. Conductive particles with a mean particle size of approximately 5 µm, which were prepared by laminating a nickel layer on the surface of benzoguanamine particles followed by laminating a gold layer, were added to the epoxy composition in an amount of 3% by volume of the final solid, and stirred until the conductive particles were thoroughly dispersed. Separately, 0.101 g of an ultraviolet activatable cationic polymerization catalyst (Irgacure™ 261, available from Nippon Ciba Geigy Ltd., cumene-cyclopentadienyl iron hexafluorophosphate), 0.0308 g of a cationic polymerization inhibitor (N,N-dimethyl-m-toluidine), 0.084 g of a reaction promoter (di-tert-butyloxalate), 0.2 g of a silane coupling agent (A187, available from Nippon Unicar Co. Ltd., γ-glycidoxypropyltrimethoxysilane) and 0.6 g of methyl ethyl ketone were combined and stirred to uniformity. This mixture was then added to and stirred with the aforementioned conductive particle dispersion to obtain an ultraviolet activatable anisotropically conductive adhesive. This adhesive was coated onto a silicone-treated polyester film, used here as a separator, using a knife coater, and dried for 10 minutes at 60°C to obtain an ultraviolet activatable anisotropically conductive adhesive film with a thickness of 20 µm.

### Fabrication of Connection Test Strip for Circuit Substrate

Samples of an ultraviolet activatable anisotropically conductive adhesive film produced as stated above measuring 2 mm x 4 cm were irradiated for 20 seconds with ultraviolet light having an intensity of either 150 mW/cm² or 180 mW/cm² at 356 nm. The samples were irradiated using the ultraviolet light sources as indicated in Table 1 and were cooled with a stream of air. The ultraviolet sources 2 and 3 indicated in Table 1 have a filter to eliminate visible light with wavelengths in the range between 450 to 600 nm and ultraviolet light with wavelengths no greater than 300 nm.

The ultraviolet irradiated adhesive film was pre-tacked onto a 0.1. mm thick polyester film having an ITO (Indium Tin Oxide) film on the surface at a temperature of 30°C and a pressure of 1.0 MPa for 4 seconds. The polyester film, which is a separator, was removed from the adhesive film. Then, a flexible printed circuit of 25 µm-thick polyimide film having 12 µm-thick and 35 µm-wide gold plated copper traces at a 70 µm pitch was placed onto the pre-tacked adhesive film on the ITO-polyester film. This piece was heat-pressed at 120°C at a pressure of 1.0 MPa for 10 seconds. The temperature at the adhesive film between the two circuits rose to 120°C in 10 seconds as the bonding head touched the substrate.

**TABLE 1.**

| UV Source | | |
|---|---|---|
| | UV Source Description | UV Irradiation |
| UV Source 1 | Mercury-Xenon lamp source L5662-01 uniformly exposing adapter E6255 (Hamamatsu Photonics K.K.) | 180 mW/cm² 20 seconds |
| UV Source 2 | Mercury-Xenon lamp source L5662-01 uniformly exposing adapter E6255, Filter A6562 (Hamamatsu Photonics K.K.) | 180 mW/cm² 20 seconds |
| UV Source 3 | Metal-halide lamp source UVH-0121C DUV Filter (Ushio Inc.) | 150 mW/cm² 20 seconds |

### Testing

Electrical interconnection resistance between the flexible circuit and ITO-polyester film was measured with a digital multimeter and the results are shown in Table 2. Bondline was visibly tested using a microscope (× 100) to see voids in the connected part. All of the bonded parts had no voids. Electrical interconnection resistance was sound when circuits were bonded within 15 minutes after ultraviolet irradiation at 27°C and 60% relative humidity. Further, these samples showed deterioration of the substrate.

**TABLE 2.**

| Test Results | | |
|---|---|---|
| Electrical interconnection | Open Time from UV irradiation to Bonding (27°C/60% RH) | |
| resistance (Max) | 2 minutes | 15 minutes |
| UV Source 1 | 326Ω | 329Ω |
| UV Source 2 | 388Ω | 356Ω |
| UV Source 3 | 315Ω | 331Ω |

## Claims

1. A method for adhering two substrates comprising irradiating a light activatable adhesive film to activate the film, wherein the light activatable adhesive film comprises an alicyclic epoxy resin, a glycidyl group-containing epoxy resin, a light activatable cationic polymerization catalyst, a cationic polymerization inhibitor, and a thermoplastic elastomer or resin and optionally wherein the glycidyl group-containing epoxy resin comprises an average of at least two glycidyl groups per molecule, contacting the first surface of the activated adhesive film with a first substrate, contacting a second substrate with the second surface of said activated adhesive film, and compression bonding these substrates; optionally wherein the light activatable adhesive film is irradiated with ultraviolet light.

2. A method according to claim 1, wherein circuits provided on the surfaces of two substrates are electrically connected, the method comprising irradiating a light activatable adhesive film to activate the film, contacting the first surface of the activated anisotropically conductive adhesive film with the circuit on a first substrate, contacting the circuit on a second substrate with the second surface of said activated anisotropically conductive adhesive film, and compression bonding these substrates to attain anisotropically conductive adhesion between said circuits on said fitst and second substrates, wherein the light activatable adhesive film comprises an alicyclic epoxy resin, a glycidyl group-containing epoxy resin, a light activatable cationic polymerization catalyst, a cationic polymerization inhibitor, and a thermoplastic elastomer or resin and optionally wherein the glycidyl group-containing epoxy resin comprises an average of at least two glycidyl groups per molecule; and optionally wherein the light activatable adhesive film is irradiated with ultraviolet light:

3. A method according to claim 1 or 2, wherein the alicyclic epoxy resin comprises an average of at least two alicyclic epoxy groups per molecule.

4. A method according to any of claims 1 to 3, wherein the alicyclic epoxy resin comprises from 90 to 500 epoxy equivalents.

5. A method according to claim 4, wherein the alicyclic epoxy resin comprises from 210 to 235 epoxy equivalents.

6. A method according to any of claims 1 to 5, wherein the alicyclic epoxy resin is vinylcyclohexene dioxide, 3,4-epoxycyclohexylmethyl-3,4-epoxycyclohexanecarboxylate, bis(3,4-epoxycyclohexyl)adipate, or 2-(3,4-epoxycyclohexyl-5,5-spiro-3,4-epoxy)cyclohexane-meta-dioxane.

7. A method according to any of claims 1 to 6, wherein the glycidyl group-containing epoxy resin comprises from 170 to 5500 epoxy equivalents.

8. A method according to claim 7, wherein the glycidyl group-containing epoxy resin comprises from 175 to 210 epoxy equivalents.

9. A method according to any of claims 1 to 8, wherein the glycidyl group-containing epoxy resin comprises glycidyl esters of bisphenol A, glycidyl esters of bisphenol F, polyfunctional phenol-novolac epoxy resins, ortho-cresol epoxy resins, or glycidyl hexahydrophthalate.

10. A method according to any of claims 1 to 9, wherein the weight ratio of alicyclic epoxy resin to glycidyl group-containing epoxy resin is from 20:80 to 98:2.

11. A method according to claim 10, wherein the weight ratio of alicyclic epoxy resin to glycidyl group-containing epoxy resin is from 50:50 to 80:20.

12. A method.according to any of claims 1 to 11, wherein the light activatable cationic polymerization catalyst is an aryldiazonium salt, diaryliodonium salt, triarylsulfonium salt, triarylselenium salt, or iron-arene complex, and optionally wherein the iron-arene complex is xylene-cyclopentadienyl iron (II) hexafluoroantimonate, curnene-cyclopentadienyl iron (II) hexafluorophosphate or xylene-cyclopentadienyl iron (II) tris(trifluoromethylsulfonyl) methide.

13. A method according to any of claims 1 to 12, wherein the light activatable adhesive film comprises from 0.05 to 10.0 parts by weight light activatable cationic polymerization catalyst per 100 parts by weight of the epoxy resin.

14. A method according to claim 13, wherein the light activatable adhesive film comprises from 1.0 to 2.5 parts by weight light activatable cationic polymerization catalyst per 100 parts by weight of the epoxy resin.

15. A method according to any of claims 1 to 14, wherein the cationic polymerization inhibitor is a crown ether, toluidine, phosphine, or triazine.

16. A method according to any of claims 1 to 15, wherein the light activatable adhesive film further comprises from 0.1 to 30% by volume conductive particles with respect to the total volume of the composition minus the volume of the conductive particles.

17. , A method according to claim 16, wherein the light activatable adhesive film comprises from 1 to 5% by volume conductive particles with respect to the total volume of the composition minus the volume of the conductive particles.

## Patentansprüche

1. Verfahren zum Kleben von zwei Substraten, umfassend das Bestrahlen einer lichtaktivierbaren Klebstofffolie zum Aktivieren der Folie, wobei die lichtaktivierbare Klebstofffolie ein alicyclisches Epoxidharz, ein Glycidylgruppen enthaltendes Epoxidharz, einen lichtaktivierbaren kationischen Polymerisationskatalysator, einen kationischen Polymerisationsinhibitor und ein thermoplastisches Elastomer oder Harz umfasst und wobei gegebenenfalls das Glycidylgruppen enthaltende Epoxidharz durchschnittlich mindestens zwei Glycidylgruppen pro Molekül umfasst, das Kontaktieren der ersten Oberfläche der aktivierten Klebstofffolie mit einem ersten Substrat, das Kontaktieren eines zweiten Substrats mit der zweiten Oberfläche der aktivierten Klebstofffolie und das Verbinden dieser Substrate durch Kompression; wobei gegebenenfalls die lichtaktivierbare Klebstofffolie mit ultraviolettem Licht bestrahlt wird.

2. Verfahren nach Anspruch 1, wobei auf den Oberflächen der zwei Substrate bereitgestellte Schaltkreise elektrisch verbunden werden, wobei das Verfahren umfasst: Bestrahlen einer lichtaktivierbaren Klebstofffolie zum Aktivieren der Folie, Kontaktieren der ersten Oberfläche der aktivierten anisotropisch leitfähigen Klebstofffolie mit dem Schaltkreis auf einem ersten Substrat, Kontaktieren des Schaltkreises auf einem zweiten Substrat mit der zweiten Oberfläche der aktivierten anisotropisch leitfähigen Klebstofffolie und das Verbinden dieser Substrate durch Kompression zum Erzielen einer anisotropisch leitfähigen Adhäsion zwischen den Schaltkreisen auf dem ersten und dem zweiten Substrat, wobei die lichtaktivierbare Klebstofffolie ein alicyclisches Epoxidharz, ein Glycidylgruppen enthaltendes Epoxidharz, einen lichtaktivierbaren kationischen Polymerisationskatalysator, einen kationischen Polymerisationsinhibitor und ein thermoplastisches Elastomer oder Harz umfasst und wobei gegebenenfalls das Glycidylgruppen enthaltende Epoxidharz durchschnittlich mindestens zwei Glycidylgruppen pro Molekül umfasst; und wobei gegebenenfalls die lichtaktivierbare Klebstofffolie mit ultraviolettem Licht bestrahlt wird.

3. Verfahren nach Anspruch 1 oder 2, wobei das alicyclische Epoxidharz durchschnittlich mindestens zwei alicyclische Epoxygruppen pro Molekül umfasst.

4. Verfahren nach einem der Ansprüche 1 bis 3, wobei das alicyclische Epoxidharz von 90 bis 500 Epoxyäquivalente umfasst.

5. Verfahren nach Anspruch 4, wobei das alicyclische Epoxidharz von 210 bis 235 Epoxyäquivalente umfasst.

6. Verfahren nach einem der Ansprüche 1 bis 5, wobei das alicyclische Epoxidharz Vinylcyclohexendioxid, 3,4-Epoxycyclohexylmethyl-3,4-epoxycyclohexan-carboxylat, Bis(3,4-epoxycyclohexyl)adipat oder 2-(3,4-Epoxycyclohexyl-5,5-spiro-3,4-epoxy)cyclohexan-meta-dioxan ist.

7. Verfahren nach einem der Ansprüche 1 bis 6, wobei das Glycidylgruppen enthaltende Epoxidharz von 170 bis 5500 Epoxyäquivalente umfasst.

8. Verfahren nach Anspruch 7, wobei das Glycidylgruppen enthaltende Epoxidharz von 175 bis 210 Epoxyäquivalente umfasst.

9. Verfahren nach einem der Ansprüche 1 bis 8, wobei das Glycidylgruppen enthaltende Epoxidharz Glycidylester von Bisphenol A, Glycidylester von Bisphenol F, polyfunktionelle Phenol-Novolak-Epoxidharze, ortho-Cresol-Epoxidharze oder Glycidylhexahydrophthalat umfasst.

10. Verfahren nach einem der Ansprüche 1 bis 9, wobei das Gewichtsverhältnis von alicyclischem Epoxidharz zu Glycidylgruppen enthaltendem Epoxidharz von 20:80 bis 98:2 beträgt.

11. Verfahren nach Anspruch 10, wobei das Gewichtsverhältnis von alicyclischem Epoxidharz zu Glycidylgruppen enthaltendem Epoxidharz von 50:50 bis 80:20 beträgt.

12. Verfahren nach einem der Ansprüche 1 bis 11, wobei der lichtaktivierbare kationische Polymerisationskatalysator ein Aryldiazoniumsalz, Diaryliodoniumsalz, Triarylsulfoniumsalz, Triarylseleniumsalz oder Eisen-Aren-Komplex ist und wobei gegebenenfalls der Eisen-Aren-Komplex Xylol-Cyclopentadienyleisen(II)-hexafluorantimonat, Cumol-Cyclopentadienyleisen(II)-hexafluorphosphat oder Xylol-Cyclopentadienyleisen(II)-tris(trifluormethylsulfonyl)methid ist.

13. Verfahren nach einem der Ansprüche 1 bis 12, wobei die lichtaktivierbare Klebstofffolie von 0,05 bis 10,0 Gewichtsteile lichtaktivierbaren kationischen Polymerisationskatalysator pro 100 Gewichtsteile des Epoxidharzes umfasst.

14. Verfahren nach Anspruch 13, wobei die lichtaktivierbare Klebstofffolie von 1,0 bis 2,5 Gewichtsteile lichtaktivierbaren kationischen Polymerisationskatalysator pro 100 Gewichtsteile des Epoxidharzes umfasst.

15. Verfahren nach einem der Ansprüche 1 bis 14, wobei der kationische Polymerisationsinhibitor ein Kronenether, Toluidin, Phosphin oder Triazin ist.

16. Verfahren nach einem der Ansprüche 1 bis 15, wobei die lichtaktivierbare Klebstofffolie weiterhin von 0,1 bis 30 Volumen-% leitfähige Teilchen in Bezug auf das Gesamtvolumen der Zusammensetzung abzüglich des Volumens der leitfähigen Teilchen umfasst.

17. Verfahren nach Anspruch 16, wobei die lichtaktivierbare Klebstofffolie von 1 bis 5 Volumen-% leitfähige Teilchen in Bezug auf das Gesamtvolumen der Zusammensetzung abzüglich des Volumens der leitfähigen Teilchen umfasst.

## Revendications

1. Procédé d'adhésion de deux substrats, comprenant l'irradiation d'un film adhésif photo-activable pour activer le film, dans lequel le film adhésif photo-activable comprend une résine époxyde alicyclique, une résine époxyde contenant des groupes glycidyle, un catalyseur de polymérisation cationique photo-activable, un inhibiteur de polymérisation cationique, et un élastomère ou une résine thermoplastique, et éventuellement dans lequel la résine époxyde contenant des groupes glycidyle comprend en moyenne au moins deux groupes glycidyle par molécule, la mise en contact de la première surface du film adhésif activé avec un premier substrat, la mise en contact d'un deuxième substrat avec la deuxième surface dudit film adhésif activé, et le collage par compression de ces substrats ; et éventuellement dans lequel le film adhésif photo-activable est irradié par la lumière ultraviolette.

2. Procédé selon la revendication 1, dans lequel des circuits présents sur les surfaces de deux substrats sont électriquement raccordés, le procédé comprenant l'irradiation d'un film adhésif photo-activable pour activer le film, la mise en contact de la première surface du film adhésif anisotropiquement conducteur activé avec le circuit situé sur un premier substrat, la mise en contact du circuit situé sur un deuxième substrat avec la deuxième surface dudit film adhésif anisotropiquement conducteur activé, et le collage par compression de ces substrats pour obtenir une adhésion anisotropiquement conductrice entre lesdits circuits situés sur lesdits premier et deuxième substrats, dans lequel le film adhésif photo-activable comprend une résine époxyde alicyclique, une résine époxyde contenant des groupes glycidyle, un catalyseur de polymérisation cationique photo-activable, un inhibiteur de polymérisation cationique, et un élastomère ou une résine thermoplastique, et éventuellement dans lequel la résine époxyde contenant les groupes glycidyle comprend en moyenne au moins deux groupes glycidyle par molécule ; et éventuellement dans lequel le film adhésif photo-activable est irradié par la lumière ultraviolette.

3. Procédé selon la revendication 1 ou 2, dans lequel la résine époxyde alicyclique comprend en moyenne au moins deux groupes époxyde alicycliques par molécule.

4. Procédé selon l'une quelconque des revendications 1 à 3, dans lequel la résine époxyde alicyclique comprend entre 90 et 500 équivalents époxyde.

5. Procédé selon la revendication 4, dans lequel la résine époxyde alicyclique comprend entre 210 et 235 équivalents époxyde.

6. Procédé selon l'une quelconque des revendications 1 à 5, dans lequel la résine époxyde alicyclique est le dioxyde de vinylcyclohexène, le 3,4-époxycyclohexylméthyl-3,4-époxycyclohexane-carboxylate, le bis(3,4-époxycyclohexyl)adipate, ou le 2-(3,4-époxycyclohexyl-5,5-spiro-3,4-époxy)cyclohexane-méta-dioxane.

7. Procédé selon l'une quelconque des revendications 1 à 6, dans lequel la résine époxyde contenant les groupes glycidyle comprend entre 170 et 5 500 équivalents époxyde.

8. Procédé selon la revendication 7, dans lequel la résine époxyde contenant les groupes glycidyle comprend entre 175 et 210 équivalents époxyde.

9. Procédé selon l'une quelconque des revendications 1 à 8, dans lequel la résine époxyde contenant les groupes glycidyle comprend des esters glycidyliques de bisphénol A, des esters glycidyliques de bisphénol F, des résines époxydes phénol-novolaque polyfonctionnelles, des résines époxydes ortho-crésoliques, ou un hexahydrophtalate de glycidyle.

10. Procédé selon l'une quelconque des revendications 1 à 9, dans lequel le rapport pondéral de la résine époxyde alicyclique contre la résine époxyde contenant les groupes glycidyle est entre 20:80 et 98:2.

11. Procédé selon la revendication 10, dans lequel le rapport pondéral de la résine époxyde alicyclique contre la résine époxyde contenant les groupes glycidyle est entre 50:50 et 80:20.

12. Procédé selon l'une quelconque des revendications 1 à 11, dans lequel le catalyseur de polymérisation cationique photo-activable est un sel d'aryldiazonium, un sel de diaryliodonium, un sel de triarylsulfonium, un sel de triarylsélénium, ou un complexe fer-arène, et éventuellement dans lequel le complexe fer-arène est l'hexafluoro-antimoniate de (cyclopentadiényl)fer(II)-xylène, l'hexafluorophosphate de (cyclopentadiényl)fer-(II)-cumène, ou le tris(trifluorométhylsulfonyl)-méthide de (cyclopentadiényl)fer(II)-xylène.

13. Procédé selon l'une quelconque des revendications 1 à 12, dans lequel le film adhésif photo-activable comprend entre 0,05 et 10,0 parties pondérales de catalyseur de polymérisation cationique photo-activable par 100 parties pondérales de la résine époxyde.

14. Procédé selon la revendication 13, dans lequel le film adhésif photo-activable comprend entre 1,0 et 2,5 parties pondérales de catalyseur de polymérisation cationique photo-activable par 100 parties pondérales de la résine époxyde.

15. Procédé selon l'une quelconque des revendications 1 à 14, dans lequel l'inhibiteur de polymérisation cationique est un éther couronne, la toluidine, la phosphine, ou la triazine.

16. Procédé selon l'une quelconque des revendications 1 à 15, dans lequel le film adhésif photo-activable comprend en outre un pourcentage volumique de particules conductrices représentant entre 0,1 et 30 % du volume total de la composition moins le volume des particules conductrices.

17. Procédé selon la revendication 16, dans lequel le film adhésif photo-activable comprend un pourcentage volumique de particules conductrices représentant entre 1 et 5 % du volume total de la composition moins le volume des particules conductrices.
